**Europäisches Patentamt**

**European Patent Office**

**Office européen des brevets**

(11) Veröffentlichungsnummer: **0 386 459**
**A1**

(12) **EUROPÄISCHE PATENTANMELDUNG**

(21) Anmeldenummer: **90102057.8**

(22) Anmeldetag: **02.02.90**

(51) Int. Cl.⁵: **C04B 41/90, H05K 3/38,**
**H01L 21/48**

(30) Priorität: **04.03.89 DE 3907004**

(43) Veröffentlichungstag der Anmeldung:
**12.09.90 Patentblatt 90/37**

(84) Benannte Vertragsstaaten:
**CH DE FR GB IT LI NL SE**

(71) Anmelder: **CONTRAVES AG**
**Schaffhauserstrasse 580**
**CH-8052 Zürich(CH)**

(72) Erfinder: **Braendli, Gerold, Dr.**
**Schanzmättelistrasse 27**
**CH-5000 Aarau(CH)**
Erfinder: **Feurer, Ernst, Dr.**
**Im Riedli 10**
**D-7906 Blaustein-Markbronn(DE)**
Erfinder: **Sutcliffe, Emile, Dr.**
**Pilgerstrasse 32**
**CH-5405 Baden(CH)**

(54) **Verfahren zum Herstellen von Dünnschichtschaltungen.**

(57) Zum Herstellen von Dünnschichtschaltungen auf einem Substrat mit einer nicht-leitenden Oberfläche (7) wird die Oberfläche des Substrats mittels einer Plasmabehandlung vorgereinigt. Um auf die Oberfläche strukturierte Leiterbahnen aufzugringen, wird zuerst eine haftvermittelnde Grundmetallisierung aus CuCr oder NiV (3) ganzflächig aufgesputtert. Dann wird die Grundmetallisierung angeätzt und galvanisch oder stromlos selektiv mit Cu (6) verstärkt. Schliesslich wird ein nicht verstärkter Bereich der Grundmetallisierung weggeätzt.

FIG.2

FIG.3

FIG.4

FIG.5

FIG.6

FIG.7

EP 0 386 459 A1

Xerox Copy Centre

# Verfahren zum Herstellen von Dünnschichtschaltungen

## Technisches Gebiet

Die Erfindung betrifft ein Verfahren zum Herstellen von Dünnschichtschaltungen, bei welchem ein Substrat mit einer nicht-leitenden Oberfläche gemäss einem semi-additiven Verfahren selektiv mit einer Leiterbahn aus Cu beschichtet wird.

## Stand der Technik

Ein Verfahren zum Herstellen von Dünnschichtschaltungen auf Keramiksubstraten offenbart das Schweizer Patentgesuch CH-5062/87-2. Dieses Verfahren zeichnet sich aus durch das Aufsputtern einer kombinierten Haft/Leitschicht auf das Substrat und ein selektives Verstärken dieser Schicht mit Cu. Die Verwendung der kombinierten Haft/Leitschicht vereinfacht den im Rahmen der selektiven Verstärkung nötigen Aetzprozess beträchtlich. Aufgrund des speziellen Substratmaterials ist es jedoch nicht möglich, dieses Verfahren direkt für die Herstellung von Mehrlagenschaltungen, bei welchen meist nicht-keramische Materialien zur Anwendung gelangen, einzusetzen.

Ein Verfahren zum Herstellen von Mehrlagenschaltungen ist z.B. aus der Veröffentlichung "Advanced Copper/Polymer/Hybrid Technology", Hayato Takasago et al., Materials & Electronic Devices Laboratory, Mitsubishi Electric Company, 1986 IEEE, bekannt. Dabei werden auf ein $Al_2O_3$ Substrat nach einem sog. voll-additiven Prozess eine erste Schicht von Leiterbahnen und dann nach einem sog. semi-additiven Prozess weitere Lagen aufgebracht, welche jeweils durch eine Polyimidschicht voneinander isoliert sind. Um die Cu-Leiterbahnen aufbringen zu können, müssen die isolierenden Oberflächen jeweils mit Katalysatoren vorbehandelt werden. Ein verfahrensökonomischer Nachteil dieses Verfahrens liegt ausserdem darin, dass für verschiedene Lagen der Mehrlagenschaltung unterschiedliche Herstellungsprozesse erforderlich sind.

Wie aus der Druckschrift "Multilayering with Polyimide Dielectric and Metallo-organic Conductors" P.H. Nguyen et al., Solid State Technology, September 1986, bekannt ist, eignen sich Polyimidfilme wegen ihrer geringen Dielektrizitätskonstanten und ihrer Fähigkeit zur Bildung von hochauflösenden Strukturen besonders gut als isolierende Zwischenschichten in Mehrlagenschaltungen.

## Darstellung der Erfindung

Aufgabe der Erfindung ist es, ein Verfahren der eingangs genannten Art anzugeben, welches sich zum Herstellen von Dünnschichtschaltungen auf keramischen wie auch auf nicht-keramischen Substraten, wie z.B. Polyimid, gleichgut eignet. Insbesondere soll die Haftfestigkeit von derart erzeugten Leiterbahnen möglichst gross sein, zumindest aber vergleichbar mit der Haftfestigkeit, wie sie bei der konventionellen NiCr-Haftschicht-Technik erreichbar ist.

Erfindungsgemäss besteht die Lösung darin, dass

a) die Oberfläche des Substrats (7) mittels einer Plasmabehandlung vorgereinigt wird,

b) eine haftvermittelnde Grundmetallisierung (3) aus CuCr oder NiV ganzflächig aufgesputtert wird,

C) und dann selektiv mit Cu verstärkt wird, und

d) dass schliesslich ein nicht verstärkter Bereich der Grundmetallisierung (3) weggeätzt wird.

Vorzugsweise werden ausserdem folgende Schritte durchgeführt:
- Vorreinigen der Oberfläche des Substrats mit einer Argon-Plasmabehandlung;
- Anätzen der Grundmetallisierung vor dem Verstärken mit Cu;
- Entfernen von Cr-Resten, welche beim Anätzen der Grundmetallisierung zurückbleiben, mit einem Chromätzmittel;
- Wegätzen der nicht-verstärkten Bereiche der Grundmetallisierung mit einem Ammoniumchloridhaltiges Aetzmittel.

Das erfindungsgemässe Verfahren eignet sich insbesondere zum Aufbringen von Leiterbahnen auf folgende Materialien:
- Polyimid,
- eine mit einem photosensitiven Polyimid beschichtete Keramik,
- Fluorpolymer oder thermoplastischer Kunststoff,
- siebgedruckte und eingebrannte Isolationsschichten,
- Na- und Bor-Glas und
- Dünnschicht- und Dickschichtkeramiken.

Zum Herstellen einer Mehrlagenschaltung wird eine Keramik als Substrat verwendet, auf welcher im Sinn der Mehrlagentechnik abwechslungweise strukturierte Leiterbahnen und isolierende Schichten aus Polyimid aufgebracht werden.

Aus den abhängigen Patentansprüchen ergeben sich weitere Ausführungsformen der Erfindung

## Kurze Beschreibung der Zeichnung

Nachfolgend soll die Erfindung anhand von Ausführungsbeispielen im Zusammenhang mit der Zeichnung näher erläutert werden. Es zeigen:

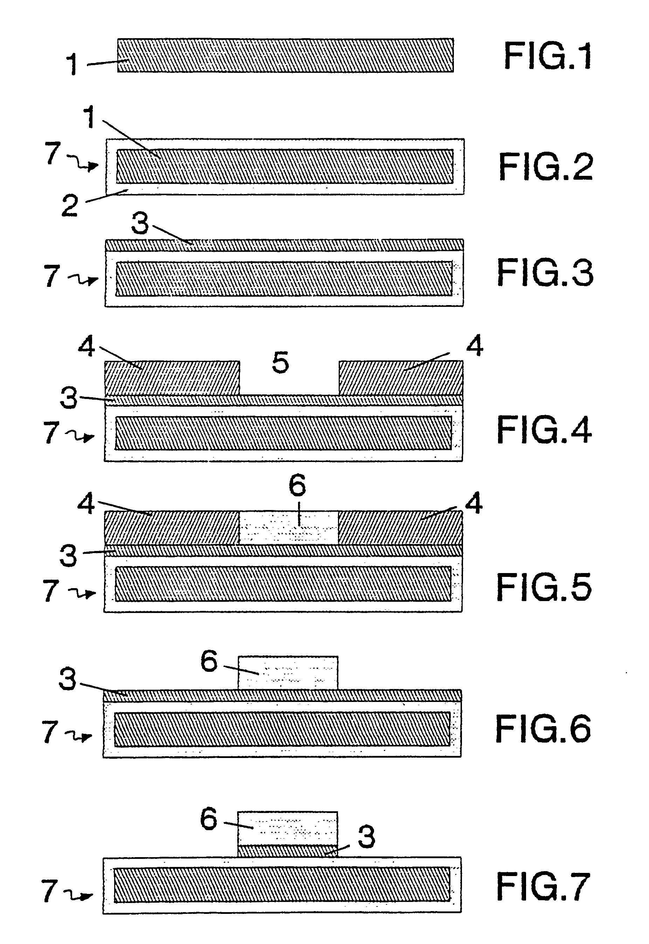

Fig. 1-7 eine schematische Darstellung der Schritte eines erfindungsgemässen Verfahrens.

Die in der Zeichnung verwendeten Bezugszeichen und deren Bedeutung sind in der Bezeichnungsliste zusammenfassend tabelliert.

## Wege zur Ausführung der Erfindung

Ausgangspunkt einer bevorzugten Ausführungsform ist eine Keramik 1 (Fig. 1). Diese wird mit einer Polyimidschicht 2 von z.B. 15 μm Dicke rundum bedeckt (Fig. 2). Dies lässt sich z.B. mit einem Spin-on Verfahren, wie es in der eingangs zitierten Schrift von P.H. Nguyen et al. beschrieben wird, erreichen. Damit liegt ein Substrat 7 mit einer nichtleitenden, nicht-keramischen Oberfläche vor.

Es ist natürlich nicht nötig, die Keramik 1 rundum mit Polyimid zu beschichten. Dies ist nur eine Massnahme, die bei speziellen Ausführungsformen in Zusammenhang mit doppelseitig verwendeten Leiterplatten von Vorteil sein kann.

Die Oberfläche des Substrats 7 wird nun sorgfältig gewaschen und entfettet. Dann wird das Substrat 7 in eine Vakuumanlage gebracht, in welcher die Oberfläche einer Argon- Plasmabehandlung unterworfen wird. Bei dieser Vorreinigung werden einerseits Verschmutzungen, welche noch auf der Oberflächen haften, entfernt. Andererseits wird bei Polyimid auch die Oberfläche aufgerauht. Dieses sogenannte Sputterätzen sollte etwa 5 Minuten dauern.

Als nächstes wird ganzflächig eine Grundmetallisierung 3 aus CuCr oder NiV mit einer Dicke von ca. 0.2 - 1 μm aufgesputtert (Fig. 3). Mit Vorteil wird ein einziges Target verwendet. Die Grundmetallisierung enthält zum überwiegenden Teil Cu resp. Ni. Cr resp. V machen jeweils nur einen kleinen Anteil der Schicht aus. Im Fall von CuCr sind es etwa 5 - 15 Atom-% Cr und im Fall von NiV etwa 7 Gew.-% V. Weitere Einzelheiten betreffend Zusammensetzung und Herstellung der genannten Grundmetallisierung 3 sind dem eingangs zitierten Schweizer Patentgesuch CH-5062/87-2 zu entnehmen.

Als nächstes wird die Grundmetallisierung 3 angeätzt. sodass die Haftung einer nachfolgend aufzubringenden Leiterbahn gewährleistet ist. Es ist darauf zu achten, dass Cr-Reste, welche allenfalls auf der Oberfläche zurückgeblieben sind, entfernt werden. Die Cr-Reste können mit gebräuchlichen Chrom-Aetzmitteln entfernt werden.

Nun folgt die selektive Beschichtung mit Cu gemäss einem semi-additiven Prozess. Dazu wird die Grundmetallisierung 3 selektiv mit einem Photolack 4 abgedeckt (Fig. 4). Je nach Feinheit der zu erreichenden Strukturen wird ein Flüssig-oder Trokkenresist verwendet. Ein nicht vom Photolack 4 abgedeckter Bereich 5 der Grundmetallisierung 3 wird nun galvanisch oder stromlos mit Cu verstärkt (Fig. 5). Dadurch entstehen die gewünschten Leiterbahnen 6, welche typischerweise eine Dicke von mehreren μm haben.

Im nächsten Schritt wird der Photolack 4 entfernt (Fig. 6).

Der chemische Fertigungsablauf endet mit dem Wegätzen der Grundmetallisierung 3 in den Bereichen, die zuvor mit Photolack 4 bedeckt waren und deshalb nicht mit Cu verstärkt worden sind (Fig. 7). Für diese Aetzung wird neben den konventionellen Cu-Aetzmitteln noch ein alkalisches Kalium-Hexacyanoferrat-Bad zum Entfernen von Cr-Resten verwendet.

Bei Bedarf kann die Leiterbahn 6 noch stromlos vergoldet werden (Au-Finish).

Im folgenden werden nun einige weitere, vorteilhafte Ausführungsformen der Erfindung beschrieben.

Wie bereits gesagt, schafft die Erfindung ein Verfahren, welches sowohl auf keramischen wie auch auf nicht-keramischen Oberflächen gut haftende Leiterbahnstrukturen erzeugt. Aus diesem Grund ist es grundsätzlich nicht nötig, die Keramik 1 mit einer Polyimidschicht 2 zu überziehen. Die Leiterbahnen können ebensogut direkt auf die Keramik, oder auf ein Substrat aus Glas oder Quarz aufgebracht werden. Insbesondere bei der Anwendung auf Mehrlagenschaltungen wird die erste Lage aus Leiterbahnen vorzugsweise direkt auf das Substrat aufgebracht. Für die nachfolgenden, weiteren Lagen stellt dann jeweils das polyimidbeschichtete Substrat - wie in Fig. 2 gezeigt, jedoch mit strukturierten Leiterbahnen unter der Polyimidschicht - den Ausgangspunkt des erfindungsgemässen Verfahrens dar.

Wenn eine Dickschichtkeramik als Substratmaterial verwendet wird, muss das mit der ganzflächigen Grundmetallisierung bedeckte Substrat in einem Vakuumofen bei ca. 400 °C ausgeheizt werden. Damit kann einer Blasenbildung vorgebeugt werden.

Interessant ist auch die Anwendung, bei welcher die Leiterbahnen auf einen thermoplastischen Kunststoff aufgebracht werden. Dadurch ist es möglich, Schaltungen direkt auf ein Gehäuse eines Geräts aufzubringen.

Des weitern ermöglicht die Erfindung, Leiterbahnstrukturen auf Polyimidsubstraten, z.B. auf Folien aus Polyimid, sog. Kapton, aufzubringen.

Im Hinblick auf Schaltungen im Mehrlagentechnik besonders bedeutsam sind photosensitive Polyimidschichten als Substratoberfläche. Zur Herstellung solcher Schaltungen wird das erfindungsgemässe Verfahren mehrfach wiederholt, wobei zwischen den derart hergestellten Leiterbahnlagen Polyimidfilme aufgebracht und mit den erforderlichen Durchkontaktierungen versehen werden. Dabei wird die erste Leiterbahnlage vorzugsweise direkt auf eine Keramik aufgebracht. Die photosensitive Eigenschaft der Polyimidfilme vereinfacht die Strukturierung (z.B. Herstellen von Durchkontaktierungen) der isolierenden Filme zwischen den Leiterbahnlagen beträchtlich.

Als Kriterium für die Güte eines Dünnfilmaufbaus kann die Haftfestigkeit auf dem Substrat herangezogen werden. Sie kann durch den Peeltest ermittelt werden. Dazu werden 1 mm breite Streifen auf dem Substrat strukturiert und dann mit einer konstanten Geschwindigkeit senkrecht abgezogen (abgeschält). Die dazu benötigte Kraft ist ein direktes Mass für die Haftung. Im Versuch hat sich gezeigt, dass CuCr und NiV auf Keramik eine Haftfestigkeit aufweisen, welche mit derjenigen der konventionellen NiCr-Haftschicht vergleichbar ist. Die Haftung der Metallisierung übersteigt die Bruchfestigkeit der Keramik. Auf Polyimid wurde für CuCr eine Haftfestigkeit von 1.3 N/mm nach dem Tempern auf 130 °C und ebenso nach Tempern auf 400 °C gemessen. NiV wies nach Tempern bei 120 °C sogar eine Peelfestigkeit von 1.5 N/mm auf. Sie fiel bei Tempern quf 400 °C jedoch wieder zurück. Bezüglich Haftfestigkeit sind die beiden Legierungen somit ein vollwertiger Ersatz für die konventionelle Cr-Haftschicht.

Das erfindungsgemässe Herstellungsverfahren zeichnet sich durch folgende Vorteile aus:

1. Haftfeste Metallisierung auf Polyimid und den oben erwähnten Materialien. Besonders der häufig verwendete Kupfer-Polyimid-Verbund zeigt eine hohe Haftfestigkeit (bis zu 1.5 N/mm, Peeltest).

2. Leichte Aetzbarkeit der kombinierten Haft/Leitschicht CuCr bzw. NiV in Gegenwart unedler Metalle oder leicht ätzbarer Isolatorschichten. Damit können aus der Leiterplattentechnik gängige Metallkobinationen auch auf Polyimid und auf Keramik realisiert werden.

Die Erfindung lässt sich in vielen Bereichen anwenden, wovon nachfolgend nur die wichtigsten genannt werden:
- Mehrlagentechnik,
- Chip Carrier Technik,
- Folienschalter,
- flexible Leiterplatten
- dreidimensionale Formkörper mit Leiterbahnen.

Insgesamt liegt mit der Erfindung ein Verfahren vor, welches sich gleichgut für keramische wie kunststoffartige Substrate eignet. Hervorzuheben sind die erreichbaren, gut Hafteigenschaften von Cu-Leiterbahnen auf Polyimid.

## BEZEICHNUNGSLISTE

1 Keramik
2 Polyimidschicht
3 Grundmetallisierung
4 Photolack
5 nichtabgedeckter Bereich
6 Leiterbahn
7 Substrat

## Ansprüche

1. Verfahren zum Herstellen von Dünnschichtschaltungen, bei welchem ein Substrat mit einer nicht-leitenden Oberfläche gemäss einem semi-additiven Verfahren selektiv mit einer Leiterbahn aus Cu beschichtet wird, dadurch gekennzeichnet, dass
a) die Oberfläche des Substrats (7) mittels einer Plasmabehandlung vorgereinigt wird,
b) eine haftvermittelnde Grundmetallisierung (3) aus CuCr oder NiV ganzflächig aufgesputtert wird,
c) und dann selektiv mit Cu verstärkt wird, und
d) dass schliesslich ein nicht verstärkter Bereich der Grundmetallisierung (3) weggeätzt wird.

2. Verfahren nach Anspruch 1, dadurch gekennzeichnet, dass
a) die Grundmetallisierung (3) vor dem Verstärken mit CU angeätzt wird und
b) die beim Anätzen der Grundmetallisierung (3) zurückbleibenden Reste von Cr mit einem Chromätzmittel entfernt werden.

3. Verfahren nach Anspruch 1, dadurch gekennzeichnet, dass ein Substrat (7) aus Polyimid verwendet wird.

4. Verfahren nach Anspruch 1, dadurch gekennzeichnet, dass als Substrat (7) eine mit einem Polyimid beschichtete Keramik verwendet wird.

5. Verfahren nach Anspruch 1, dadurch gekennzeichnet, dass ein Substrat (7) aus Fluorpolymer oder thermoplastischem Kunststoff verwendet wird.

6. Verfahren nach Anspruch 1, dadurch gekennzeichnet, dass ein Substrat (7) mit einer siebgedruckten und eingebrannten Isolationsschicht als Oberfläche verwendet wird.

7. Verfahren nach Anspruch 1, dadurch gekennzeichnet, dass die Oberfläche des Substrats (7) mit einer Argon-Plasmabehandlung vorgereinigt wird.

8. Verfahren nach Anspruch 1, dadurch gekennzeichnet, dass eine Keramik als Substrat (7) verwendet wird, und dass im Sinn einer Mehrlagentechnik abwechslungweise strukturierte Leiterbahnen und isolierende Schichten aus Polyimid aufgebracht werden.

9. Verfahren nach Anspruch 1, dadurch gekennzeichnet, dass zum selektiven Verstärken der Grundmetallisierung

a) die Grundmetallisierung (3) in nicht zu verstärkenden Bereichem mit einem Photolack (4) abgedeckt wird,

b) die nicht mit Photolack (4) abgedeckten Bereiche (5) der Grundmetallisierung (3) galvanisch oder stromlos verstärkt werden, und

c) anschliessend der Photolack (4) entfernt wird.

10. Verfahren nach Anspruch 1, dadurch gekennzeichnet, dass zum Wegätzen der nicht-verstärkten Bereiche der Grundmetallisierung (3) ein Ammoniumchlorid-haltiges Aetzmittel und ein alkalisches Kalium-Hexacyanoferrat-Bad verwendet werden.

FIG.1

FIG.2

FIG.3

FIG.4

FIG.5

FIG.6

FIG.7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 444 848 (SHANEFIELD et al.) * Zusammenfassung; Spalte 1, Zeilen 8-41; Spalte 2, Zeilen 14-36; Spalte 3, Zeile 32 - Spalte 4, Zeile 11; Spalte 5, Zeilen 6-7,49-61; Spalte 7, Zeilen 3-14 * | 1,7,9 | C 04 B 41/90 H 05 K 3/38 H 01 L 21/48 |
| Y | | 4-5,10 | |
| P,Y | DE-A-3 837 009 (BBC BROWN BOVERI AG) * Zusammenfassung; Ansprüche 1,3-5,7-8; Spalte 3, Zeilen 22-47; Spalte 4, Zeilen 28-66 * | 1,3 | |
| Y | EP-A-0 215 557 (GOULD INC.) * Ansprüche 1,5,7-9; Seite 8, Zeile 13 - Seite 9, Zeile 19; Seite 10, Zeilen 14-22; Seite 11, Zeilen 2-5; Seite 12, Zeilen 10-13 * | 1,3 | |
| Y | THIRD IEEE/CHMT INTERNATIONAL ELECTRONIC MANUFACTURING TECHNOLOGY SYMPOSIUM, Anaheim, 12. - 14. Oktober 1987, Seiten 178-183, IEEE, New York, US: T. OHSAKI et al.: "A fine-line multilayer substrate with photo-sensitive polyimide dielectric and electroless copper plated conductors" * Spalte 1, Zeile 56 - Spalte 4, Zeile 12 * -/- | 4,8 | |

|  |
|---|
| **RECHERCHIERTE SACHGEBIETE (Int. Cl.5)** |
| C 04 B 41 H 05 K 3 H 01 L 21 C 23 F 1 |

Der vorliegende Recherchenbericht wurde für alle Patentansprüche erstellt

| Recherchenort | Abschlußdatum der Recherche | Prüfer |
|---|---|---|
| DEN HAAG | 25-04-1990 | OLSSON S.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument

EPO FORM 1503 03.82 (P0403)

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | APPLIED PHYSICS LETTERS, Band 51, Nr. 2, Juli 1987, Seiten 103-105, American Institute of Physics, New York, US; C.-A. CHANG et al.: "Enhanced Cu-teflon adhesion by presputtering prior to the Cu deposition" * Spalte 1, Zeile 27 - Spalte 2, Zeile 10 * --- | 5 | |
| Y | SOLID STATE TECHNOLOGY, Juli 1973, Seiten 36-40; R.E. HICKS; "Thin-film electroplated funnel thru-holes on polyimide resin and laminated boars" * Spalte 3, Zeile 50 - Spalte 4, Zeile 28; Spalte 6, Zeile 10 - spalte 7, Zeile 12 * ----- | 10 | |
| | | | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 25-04-1990 | OLSSON S.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)